# EUROPEAN PATENT SPECIFICATION

(11) **EP 2 955 737 B1**
(45) Date of publication and mention of the grant of the patent: **18.07.2018**
(21) Application number: 14749406.6
(22) Date of filing: 07.02.2014
(51) Int. Cl.: H01H 36/00, B62D 1/04, G01D 5/24, H03K 17/96

(54) **CAPACITANCE SENSOR AND STEERING**
KAPAZITÄTSSENSOR UND LENKUNG
CAPTEUR DE CAPACITÉ ET DIRECTION

(30) Priority: 08.02.2013 JP 2013023506
(43) Date of publication of application: 16.12.2015
(73) Proprietor: Fujikura Ltd., Tokyo 135-8512 (JP)
(72) Inventor: KARASAWA, Noriyuki, Tokyo 135-8512 (JP); YAJIMA, Fumio, Tokyo 135-8512 (JP); IGUCHI Yusuke, Sakura-shi Chiba 285-8550 (JP)
(74) Representative: Grünecker Patent- und Rechtsanwälte PartG mbB
(86) International application number: PCT/JP2014/052908
(87) International publication number: WO 2014/123222

(56) References cited:
- DE-A1-102009 058 138
- JP-A- H05 345 569
- JP-A- S63 305 074
- JP-A- 2005 537 992
- JP-A- 2008 087 566
- JP-A- 2009 208 559
- JP-A- 2013 082 423
- US-A1- 2009 199 676

## Description

### TECHNICAL FIELD

This invention relates to an electrostatic capacitance sensor employed in a steering of an automobile and to the steering.

### BACKGROUND ART

An electrostatic capacitance sensor that covers a steering of an automobile by a metal tape and detects whether a hand of an occupant is touching the steering or not, is known from JP S63-305074 A (Patent Document 1). The electrostatic capacitance sensor detects whether the hand of the occupant is touching the steering or not by detecting a change in electrostatic capacitance between the hand of the occupant and said metal foil, has, for example, a heater installed in the steering, and may also be used in ON/OFF control of this heater, or may also be used in control of an airbag, or the like.

DE 10 2009 058138 A1, considered as the closest prior art according to the preamble of claims 1 and 7, relates to a method manufacturing a proximity sensor.
The method involves forming conductive threads e.g. weft threads and warp threads, of an upper fabric layer and a lower fabric layer such that some of the threads having a magnitude are electrically connected with each other and some of the threads having another magnitude are electrically connected with each other. The threads having different magnitudes are insulated from each other such that capacitances are produced between the threads having different magnitudes, where the capacitances change depending on an object approaching the layers.

JP 2008 087566 A relates to a mechanism for a steering wheel to detect the contact position of an occupant on the steering wheel. In detail, pluralities of electrodes are arranged along the arc of the steering wheel. These electrodes detect the position where an occupant contacts the steering.

US 2009/199676 A1 discloses a sensor system for a steering wheel rim. The sensor comprises an outer conductor and an inner conductor. According to this document a change of the capacitance C and/or the inductance L in the steering wheel rim is measured. The capacitance and/or the inductance are changed as a result of an acceleration, which acts on the steering wheel rim. Thus, the distance between the outer conductor and the inner conductor is changed.

JP H05 345569 discloses a sensor to detect the pressure force in a steering wheel. The pressure force sensor comprises two electrodes. The two electrodes are mounted in the steering wheel and measure the impedance of a pressure sensitive conductive rubber.

### SUMMARY OF INVENTION

### PROBLEM TO BE SOLVED BY THE INVENTION

In Patent Document 1, a frame portion of the steering (referred to below as "steering core") is covered by an insulating sheet, this place has the metal tape wrapped around it, and this is further covered by the heater and a cover pad. Therefore, a plurality of different work steps are required.

The present invention was made in view of such a problem, and has an object

The present invention was made in view of such a problem, and has an object of providing an electrostatic capacitance sensor and a steering whose installation work is easy.

### MEANS FOR SOLVING THE PROBLEM

This object is achieved by the subject matter of the independent claims. Advantageous embodiments are claimed in the dependent claims.
According to an exemplary embodiment useful for understanding the invention, an electrostatic capacitance sensor is an electrostatic capacitance sensor mounted in a steering. Moreover, an electrostatic capacitance sensor according to one mode of the present invention comprises: a flexible substrate having an insulating property; and an electrostatic capacitance detecting electrode provided on a surface of the flexible substrate, includes: a first portion following an extension direction of a steering wheel; and a second portion extending out from the first portion in a direction intersecting the extension direction of the wheel of the steering, and is formed so as to completely cover a steering core. That is, the electrostatic capacitance sensor according to the present invention can be formed from a membrane or an FPC (Flexible Printed Circuit), for example. Moreover, since it includes: the first portion following the extension direction of the steering wheel; and the second portion extending out from the first portion in the direction intersecting the extension direction of the steering wheel, and can cover an entire surface of the steering core, it is possible to provide an electrostatic capacitance sensor whose installation work is easy, without a plurality of work steps being required.

The above-described electrostatic capacitance sensor may have at least one of the first portion and the second portion divided into a plurality. Moreover, the electrostatic capacitance sensor according to the above-described mode may have a shield electrode further included on a reverse surface of the above-described flexible substrate. That is, if, for example, a metal component is included more inwardly than the above-described flexible substrate, such as the steering core, then disposing the shield electrode makes it possible to eliminate an influence on a detection signal of such a metal component. Now, the electrostatic capacitance sensor according to one mode of the present invention can be formed by the likes of the membrane or FPC, hence the shield electrode can also be formed integrally with the flexible substrate. Therefore, installation of the shield electrode can also be performed without increasing the work steps.

Moreover, the above-described electrostatic capacitance detecting electrode may be formed also in the above-described second portion. Forming the electrostatic capacitance detecting electrode also in the above-described second portion makes it possible to densify a detection range of electrostatic capacitance, thereby enabling fine detection to be achieved. Moreover, in such a case, the electrostatic capacitance detecting electrode may include a wiring of a shape bordering the above-described flexible substrate. If such a wiring is provided as a configuration element of the electrostatic capacitance detecting electrode, then even if this wiring is broken in one place, the detection signal can be transmitted to a control unit via another route.

Moreover, a steering according to the present invention comprises: a steering core; and an electrostatic capacitance sensor mounted on the steering core. This electrostatic capacitance sensor comprises: a flexible substrate having an insulating property; and an electrostatic capacitance detecting electrode provided on a surface of the flexible substrate. Moreover, this electrostatic capacitance sensor includes: a first portion following an extension direction of a wheel of the steering; and a second portion extending out from the first portion in a direction intersecting the extension direction of the wheel of the steering, and is formed so as to completely cover the steering core. Moreover, the electrostatic capacitance sensor according to the above-described mode may have a shield electrode further included on a reverse surface of the above-described flexible substrate. Furthermore, the electrostatic capacitance detecting electrode may be divided into a plurality in the direction intersecting the extension direction of the wheel of the steering, and adjacent electrostatic capacitance detecting electrodes may be configured so as to each independently be capable of detecting an electrostatic capacitance. This makes it possible to distinguish whether a hand of an occupant is touching, or is gripping the wheel by whether only one of adjacent electrostatic capacitance detecting electrodes detects the hand of the occupant, or both detect the hand of the occupant. Moreover, at that time, if the electrostatic capacitance detecting electrode is configured so as to be divided into a plurality of groups such that fellow adjacent electrostatic capacitance detecting electrodes each belong to a different group, and is configured such that a plurality of the electrostatic capacitance detecting electrodes belonging to an identical group are commonly connected, then the number of wirings from the electrode to a control device can be reduced.

Moreover, the steering according to one mode of the present invention has a heater that generates heat according to a detection signal of the electrostatic capacitance sensor included between itself and the electrostatic capacitance sensor. Furthermore, in the steering according to these modes of the present invention, the above-described steering core may be mounted with a cushioning material that covers the electrostatic capacitance sensor. Such a cushioning material has an effect of reducing unevenness occurring when the electrostatic capacitance sensor is installed in the steering core, but by integrally forming the electrostatic capacitance sensor and the above-described cushioning material, installation work to the steering can be further reduced.

### EFFECT OF THE INVENTION

The present invention makes it possible to provide an electrostatic capacitance sensor whose installation work is easy.

### BRIEF DESCRIPTION OF DRAWINGS

[Fig. 1] Fig. 1 is a schematic view showing an operation principle of an electrostatic capacitance sensor according to a first embodiment of the present invention.
[Fig. 2] Fig. 2 is a schematic view showing an arrangement example of the electrostatic capacitance sensor according to the same embodiment.
[Fig. 3] Fig. 3 is a cross-sectional view taken along the line A-A' of Fig. 2, and looking in the direction of the arrows.
[Fig. 4] Fig. 4 is a cross-sectional view taken along the line B-B' of Fig. 3, and looking in the direction of the arrows.
[Fig. 5] Fig. 5 is a plan view showing a shape of the same electrostatic capacitance sensor.
[Fig. 6] Fig. 6 is a partial front view showing a state of the same electrostatic capacitance sensor mounted on a steering core.
[Fig. 7] Fig. 7 is a cross-sectional view taken along the line C-C' of Fig. 6, and looking in the direction of the arrows.
[Fig. 8] Fig. 8 is a plan view showing a configuration of part of the same electrostatic capacitance sensor.
[Fig. 9] Fig. 9 is a plan view showing a configuration of part of the same electrostatic capacitance sensor.
[Fig. 10] Fig. 10 is a plan view showing a configuration of part of the same electrostatic capacitance sensor.
[Fig. 11] Fig. 11 is a plan view showing a configuration of part of the same electrostatic capacitance sensor.
[Fig. 12] Fig. 12 is a plan view showing a configuration of part of the same electrostatic capacitance sensor.
[Fig. 13] Fig. 13 is a plan view showing a configuration of part of the same electrostatic capacitance sensor.
[Fig. 14] Fig. 14 is a cross-sectional view showing a configuration example of part of an electrostatic capacitance sensor according to a second embodiment of the present invention.
[Fig. 15] Fig. 15 is a plan view showing a shape of an electrostatic capacitance sensor according to another embodiment of the present invention.
[Fig. 16] Fig. 16 is a plan view showing a shape of an electrostatic capacitance sensor according to another embodiment of the present invention.
[Fig. 17] Fig. 17 is a plan view showing a shape of an electrostatic capacitance sensor according to another embodiment of the present invention.
[Fig. 18] Fig. 18 is a plan view showing a shape of an electrostatic capacitance sensor according to another embodiment of the present invention.
[Fig. 19] Fig. 19 is a plan view showing a shape of an electrostatic capacitance sensor according to another embodiment of the present invention.
[Fig. 20] Fig. 20 is a plan view showing a shape of an electrostatic capacitance sensor according to another embodiment of the present invention.
[Fig. 21] Fig. 21 is a plan view showing a shape of an electrostatic capacitance sensor according to another embodiment of the present invention.
[Fig. 22] Fig. 22 is a plan view showing a shape of an electrostatic capacitance sensor according to another embodiment of the present invention.
[Fig. 23] Fig. 23 is a plan view showing a shape of an electrostatic capacitance sensor according to another embodiment of the present invention.
[Fig. 24] Fig. 24 is a plan view showing a shape of an electrostatic capacitance sensor according to another embodiment of the present invention.
[Fig. 25] Fig. 25 is a plan view showing a shape of an electrostatic capacitance sensor according to another embodiment of the present invention.
[Fig. 26] Fig. 26 is a plan view showing a shape of an electrostatic capacitance sensor according to another embodiment of the present invention.
[Fig. 27] Fig. 27 is a schematic cross-sectional view of a steering core of the embodiment of Fig. 26.

### EMBODIMENTS FOR CARRYING OUT THE INVENTION

### [1. First Embodiment]

### [1-1. Operation Principle of Electrostatic Capacitance Sensor according to First Embodiment]

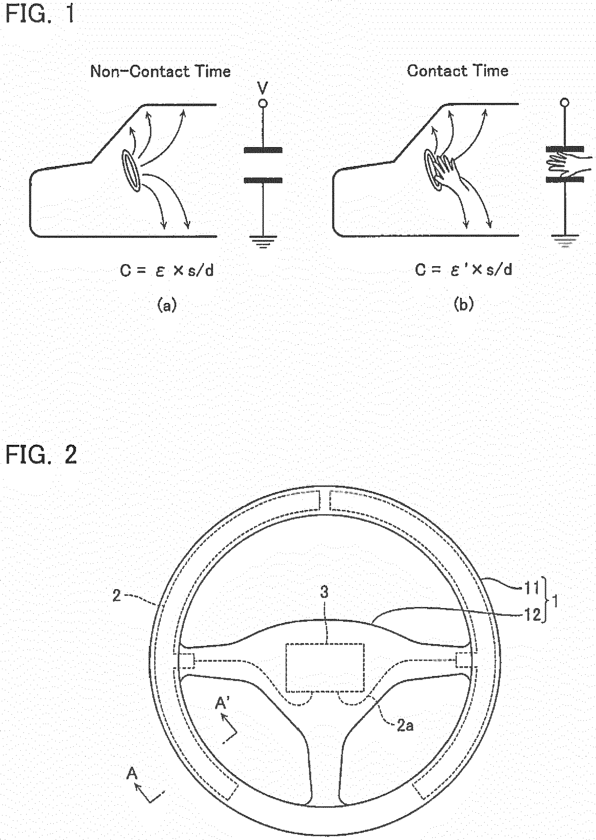

An electrostatic capacitance sensor according to a first embodiment of the present invention will be described below. An operation principle of the electrostatic capacitance sensor according to the present embodiment will be described with reference to Fig. 1. The electrostatic capacitance sensor according to the present embodiment detects a change in electrostatic capacitance between a hand of an occupant and an electrode in the electrostatic capacitance sensor, and thereby detects whether the hand of the occupant is touching a steering or not. That is, as shown in Fig. 1(a), in a state where the hand of the occupant is separated from the steering, the electrostatic capacitance sensor detects electrostatic capacitance between a car body and a metal foil. However, as shown in Fig. 1(b), when the hand of the occupant approaches the steering, the occupant ends up coming between the electrostatic capacitance sensor and the car body, hence the electrostatic capacitance detected by the electrostatic capacitance sensor changes. Therefore, when the electrostatic capacitance detected by the electrostatic capacitance sensor has attained a certain threshold value or more, it can be determined that the hand of the occupant is touching the steering.

### [1-2. Schematic Configuration of Steering and Electrostatic Capacitance Sensor according to First Embodiment]

Fig. 2 is a schematic view of the steering according to the present embodiment. An electrostatic capacitance sensor 2 according to the present embodiment is disposed inside a wheel 11 of a steering 1. In the present embodiment, the electrostatic capacitance sensor 2 is provided independently in an approximately 120° portion range to a right side from an upper portion of the wheel 11 and an approximately 120° portion range to a left side from the upper portion of the wheel 11, and detects whether each of both hands of the occupant are touching or not, for each of the ranges. Moreover, an approximately 120° portion lower side range of the wheel 11 is not provided with the electrostatic capacitance sensor 2. This is because there is a risk of a leg of the occupant touching the lower side of the wheel 11, whereby there is a risk of a misdetection that the hand of the occupant is touching the wheel 11 occurring. The electrostatic capacitance sensors 2 disposed to left and right are each connected, via a contact wiring 2a, to a control device 3 disposed in a steering column 12. The contact wiring 2a is preferably provided at a position corresponding to the steering column 12. This is because a wasteful terminal portion or wiring can thus be rendered unnecessary.

Note that in the present embodiment, the electrostatic capacitance sensor 2 is not provided in an approximately 120° portion lower side range of the wheel, but such a range not provided with the electrostatic capacitance sensor 2 can be appropriately adjusted. However, if such a range not provided with the electrostatic capacitance sensor 2 is set to less than approximately 60°, there is a risk of the leg of the occupant touching the electrostatic capacitance sensor 2, and when 180° is exceeded, there is a risk of an installation range of the electrostatic capacitance sensor ending up being less than a range touched by the hand of the occupant and it becoming impossible to appropriately detect whether the hand of the occupant is touching or not. Therefore, the range not provided with the electrostatic capacitance sensor 2 is conceivably adjusted roughly in a lower side range of not less than 60° and not more than 180°. Note that in the present embodiment, two electrostatic capacitance sensors 2 are disposed, but depending on an application, it is also possible to divide into three or more, or gather into one. For example, in such cases where it is desired to detect a position or posture of the occupant in detail, it is conceivable for the electrostatic capacitance sensor 2 to be divided in a finer range, and so on.

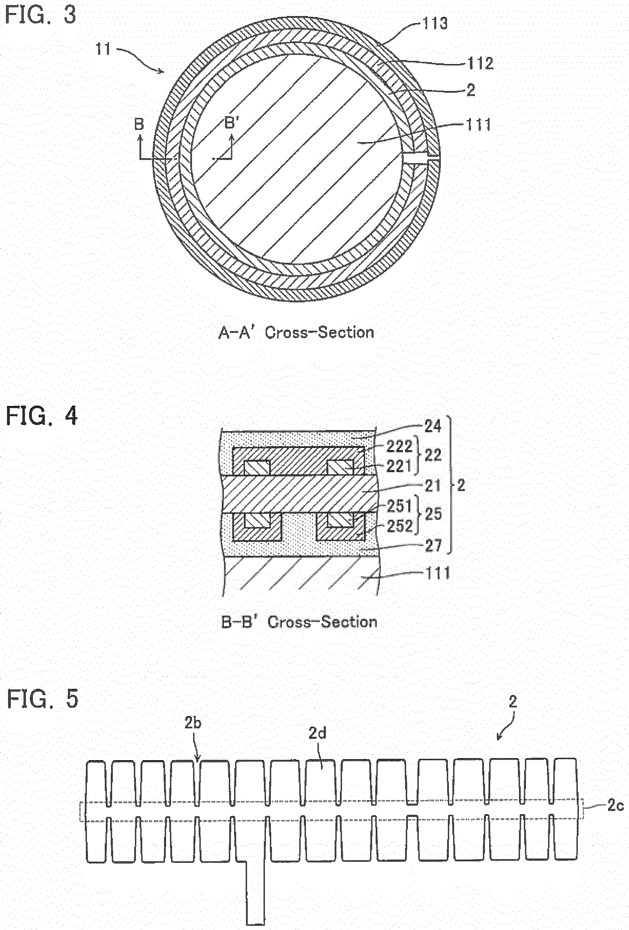

Fig. 3 is a cross-sectional view of the wheel 11 looking in the A-A' direction of Fig. 2. A central portion of the wheel 11 is a steering core 111. The steering core 111 is covered by the electrostatic capacitance sensor 2. Moreover, when the electrostatic capacitance sensor 2 is wrapped around the steering core 111, unevenness sometimes occurs in a wheel 11 surface, but such unevenness can be reduced by covering by a cushioning material 112. The cushioning material 112 can be formed by, for example, a rubber material such as a rubber sheet, or a foamed resin such as a foamed urethane. In order to absorb the unevenness created by the electrostatic capacitance sensor 2 and flatten a surface side, the cushioning material 112 is preferably provided along an entire circumference of the steering core 111. Moreover, the cushioning material 112 is covered by a steering skin 113 touched by the hand of the occupant and formed from leather, or the like. Note that adhesion of each layer is conceivably performed by, for example, a double-sided adhesive tape or an adhesive agent.

Fig. 4 is a cross-sectional view of the electrostatic capacitance sensor 2, taken along the line B-B' of Fig. 3 and looking in the direction of the arrows. The electrostatic capacitance sensor 2 comprises: a flexible substrate 21 having an insulating property; an electrostatic capacitance detecting electrode 22 that is provided on a surface of this flexible substrate 21 and detects a change in electrostatic capacitance; and a resist layer 24 covering the electrostatic capacitance detecting electrode 22. Moreover, the electrostatic capacitance sensor 2 comprises: a shield electrode 25 that is provided on a reverse surface of the flexible substrate 21 and eliminates an influence exerted on a detection signal by the likes of a metal component included in the steering core 111; and an adhesive layer 27 covering this shield electrode 25. The electrostatic capacitance detecting electrode 22 comprises: a surface wiring layer 221 provided on the surface of the flexible substrate 21; and an electrode layer 222 covering this surface wiring layer 221. The shield electrode 25 comprises: a reverse surface wiring layer 251 provided on the reverse surface of the flexible substrate 21; and a shield electrode 252 covering this reverse surface wiring layer 251. Note that in the present embodiment, the electrostatic capacitance detecting electrode 22 is configured from the surface wiring layer 221 and the electrode layer 222, but it is also possible for one of the surface wiring layer 221 and the electrode layer 222 to be omitted and the electrostatic capacitance detecting electrode 22 to be configured from only the other. Similarly, in the present embodiment, the shield electrode 25 is configured by the reverse surface wiring layer 251 and the shield electrode 252, but it is also possible for one of the reverse surface wiring layer 251 and the shield electrode 252 to be omitted and the shield electrode 25 to be configured from only the other.

### [1-3. Planar Shape of Electrostatic Capacitance Sensor 2 according to First Embodiment]

The electrostatic capacitance sensor 2 according to the present embodiment has a configuration of being formed on a substrate having flexibility, such as a membrane or an FPC (Flexible Printed Circuit). Therefore, it can be configured in a freer shape compared to when configuring an electrostatic capacitance sensor using the likes of a metal foil. As shown in Fig. 5, in a state when not installed in the steering core 111, the electrostatic capacitance sensor 2 according to the present embodiment has included on both sides of a first portion 2c a plurality of notches 2b extending in a direction orthogonal to an extension direction of the first portion 2c, whereby a second portion 2d is divided, and a plurality of the second portions 2d are formed on the both sides (in each side of upper and lower direction) of the first portion 2c. By including the plurality of notches 2b, the electrostatic capacitance sensor 2 is formed so as to be capable of being fitted to the ring-shaped steering core 111 to cover an entire surface of the steering core 111, without another portion overlapping. In other words, the electrostatic capacitance sensor 2 includes: the first portion 2c extending along an extension direction of the wheel 11, that is, an outer circumferential portion of the wheel 11; and the plurality of second portions 2d extending out in the direction orthogonal to the extension direction of this first portion 2c. The second portion 2d is formed in a trapezoidal shape, and its tip portion is narrower compared to its base end portion.

A width of the notch 2b may be set to a width of a kind that broadens with increasing distance from the first portion 2c, basically so as to prevent adjacent second portions 2d from overlapping. That is, as will be mentioned later, the first portion 2c is disposed on an outer circumference (portion where a diameter is largest) of the steering core 111, hence the width of the notch 2b at a certain position X need only be set broader than a width of a differential between a length at a most outwardly circumferential position and a length in a circumferential direction at the position X, of the steering core 111 divided by the number of notches 2b. However, if the width of the notch 2b is more than two times broader than the width of the above-described differential divided by the number of notches 2b, then a gap becomes too large, an area forming the electrostatic capacitance detecting electrode 22 becomes small, and sensitivity falls, which is therefore undesirable.

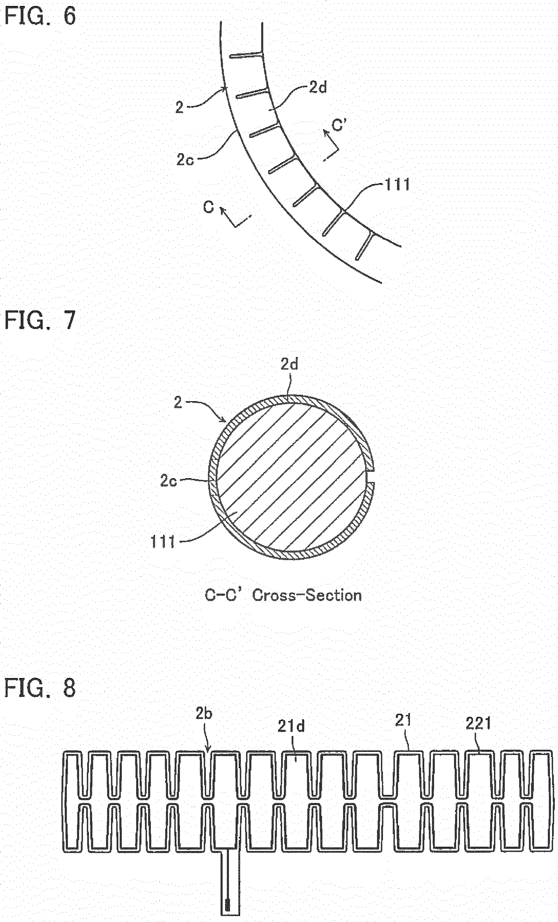

As shown in Fig. 6, during installation, the adhesive layer 27 of the first portion 2c is closely adhered to the steering core 111 along the outer circumference of the steering core 111, and then the second portion 2d is folded in toward an inner circumferential side of the steering core 111, whereby the entire surface of the steering core 111 is covered by the electrostatic capacitance sensor 2. At this time, if the plurality of notches 2b are formed so as to prevent the second portions 2d from overlapping each other, then unevenness of the steering 1 can be reduced. Moreover, by configuring so as to prevent fellow electrostatic capacitance detecting electrodes 22 from overlapping, a defect such as a parasitic capacitance value changing whereby sensitivity falls does not occur either. Furthermore, in order to sufficiently secure an area of the electrostatic capacitance detecting electrode 22 in the electrostatic capacitance sensor 2, the gap occurring when mounting the electrostatic capacitance sensor 2 in the steering core 111 is desirably as small as possible. Specifically, a broadest width of the gap is desirably not more than half of a width of the second portion 2d. As shown in Fig. 7, by the first portion 2c being mounted on a most outward circumference of the steering core 111, and the second portion 2d being wrapped around therefrom along the circumferential direction of the steering core 111, the electrostatic capacitance sensor 2 can be easily mounted in the steering core 111 without a crease occurring. Moreover, such installation work is simpler compared to when a metal tape is wrapped around the steering core 111.

### [1-4. Configuration of Each Layer of Electrostatic Capacitance Sensor 2 according to First Embodiment]

Fig. 8 is a plan view showing the flexible substrate 21 and the surface wiring layer 221 of the electrostatic capacitance sensor 2 according to the first embodiment. The flexible substrate 21 employs a film which is thin and has flexibility such as polyimide or PET, for example, and is formed in a shape described using Fig. 5 by a punching step, for example. Moreover, the surface wiring layer 221 employs the likes of silver (Ag) or copper (Cu), and is formed along an outline form shape. That is, the surface wiring layer 221 is formed also on a portion 21d corresponding to the above-mentioned second portion 2d. Therefore, a detection range of electrostatic capacitance is densified, and fine detection is achieved. Moreover, the surface wiring layer 221 has a wiring of a kind that borders a shape of the flexible substrate 21, and even in such a case that, for example, this wiring is broken in one place, the detection signal can be transmitted to the control unit 3 via another route. Moreover, the wiring is of a kind of shape that borders an outline form of the flexible substrate 21, hence a maximum detection area broadens, and detection sensitivity improves. Furthermore, the electrostatic capacitance sensor 2 according to the present embodiment can be formed from the membrane or FPC, hence a freer patterning is possible compared to a method where a metal tape is wrapped around. Therefore, a reduction in material costs can be made by disposing metal only in an effective range. Moreover, in the present embodiment, the surface wiring layer 221 can be freely patterned, and it is also possible to provide a mesh portion having a pattern like that of a later-mentioned mesh portion 251b of the reverse surface wiring layer 251, on the inside of a wiring of a kind bordering the shape of the flexible substrate 21, for example. It is conceivable that in this case, a position of the hand of the occupant can be more suitably detected. Moreover, such a mesh portion can be manufactured at a lower price, compared to a case such as where silver (Ag) or copper (Cu) is solid-coated, for example. Furthermore, in the case where, for example, the electrode layer 222 is omitted to configure the electrostatic capacitance detecting electrode 22 from the surface wiring layer 221 only, providing the above-described mesh portion in the surface wiring 221 makes it possible for manufacturing steps to be reduced without narrowing a detection range.

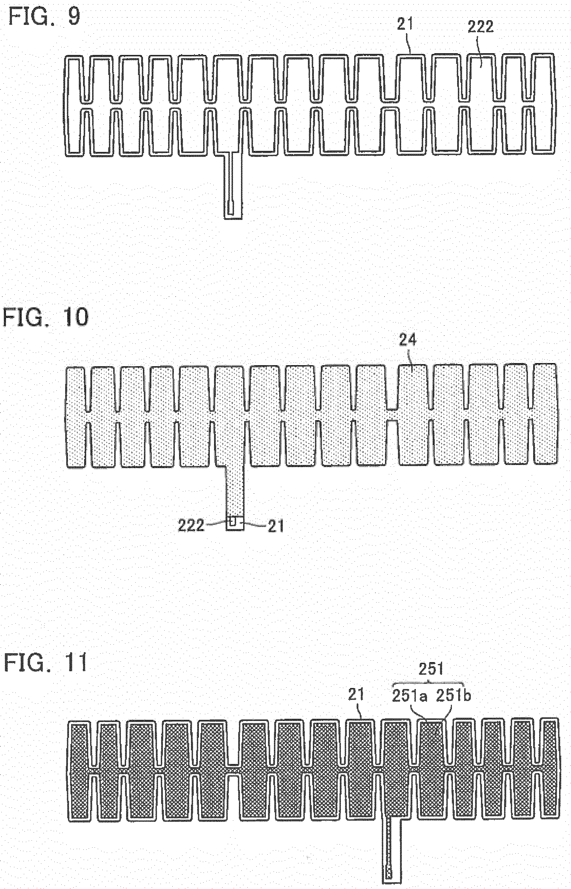

Fig. 9 is a plan view showing the electrode layer 222 of the electrostatic capacitance sensor 2 according to the first embodiment. In the present embodiment, the electrode layer 222 is formed by filling the inside of a border wiring by carbon having conductivity and flexibility, so as to cover the surface wiring layer 221 and the contact wiring 2a. The electrode layer 222 operates as an electrode for electrostatic capacitance detection of the electrostatic capacitance sensor 2. That is, the electrostatic capacitance sensor 2 according to the present embodiment inputs a potential of the electrostatic capacitance detecting electrode 22 combining the surface wiring layer 221 and the electrode layer 222, to the control device 3, via the contact wiring 2a, and thereby detects electrostatic capacitance. Moreover, Fig. 10 is a plan view showing the resist layer 24. The resist layer 24 is formed by solid-coating a resist material so as to cover up to a side surface of the electrostatic capacitance detecting electrode 22. As a result, foreign matter such as moisture is prevented from penetrating to a side of an electrostatic capacitance detecting electrode 22. Conceivably used as the resist material is a polyester one or an acrylic one.

Fig. 11 is a plan view showing the reverse surface wiring layer 251 of the electrostatic capacitance sensor 2 according to the first embodiment. The reverse surface wiring layer 251 employs the likes of silver (Ag) or copper (Cu), and includes: a border portion 251a patterned so as to border the shape of the flexible substrate 21; and the mesh portion 251b formed in a mesh shape (netlike shape) inside this border portion 251a. Therefore, even in such a case that the border portion 251a is broken in one place, a potential of the reverse surface wiring layer 251 overall can be adjusted via another route. Note that the reverse surface wiring layer 251 is configured from silver (Ag) in the present embodiment.

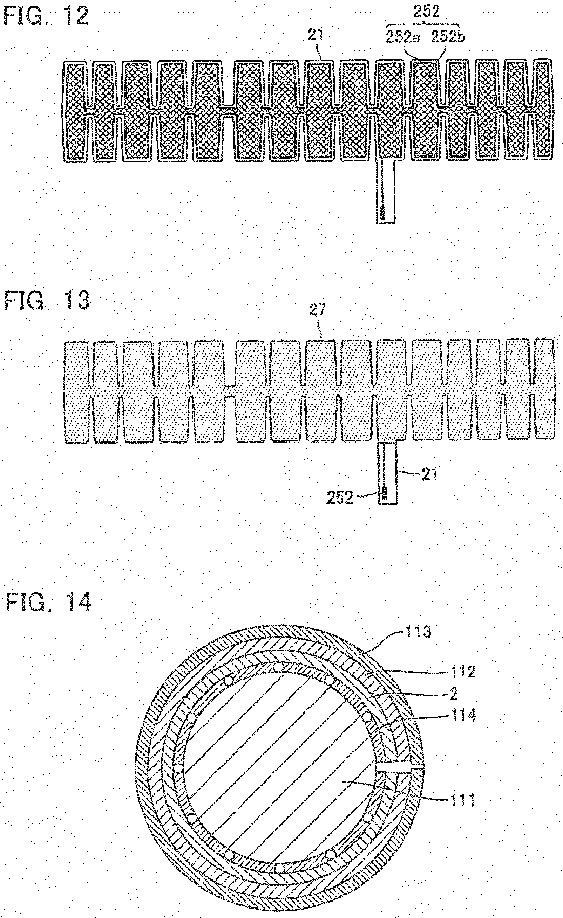

Fig. 12 is a plan view showing the shield layer 252 of the electrostatic capacitance sensor 2 according to the first embodiment. The shield layer 252 employs a carbon material having conductivity and flexibility, and includes, so as to cover the reverse surface wiring layer 251: a border portion 252a patterned so as to border the shape of the flexible substrate 21; and a mesh portion 252b formed in a mesh shape (netlike shape) inside this border portion 252a. Note that in the present embodiment, the shield layer 252 is formed from the border portion 252a and the mesh portion 252b, but may also be formed by solid-coating the above-described carbon material having conductivity and flexibility. Fig. 13 is a plan view showing the adhesive layer 27 of the electrostatic capacitance sensor 2 according to the first embodiment. The adhesive layer 27 is formed by solid-coating an adhesive material so as to cover an entire reverse surface of the flexible substrate 21. Note that these surface wiring layer 221, electrode layer 222, reverse surface wiring layer 251, shield layer 252, resist layer 24, and adhesive layer 27 can be formed by, for example, screen printing or offset printing.

### [2. Second Embodiment]

Next, a second embodiment of the present invention will be described. A steering according to the present invention is basically configured substantially similarly to the steering 1 according to the first embodiment, but as shown in Fig. 14, in the present embodiment, a heater 114 that generates heat according to a detection signal of the electrostatic capacitance sensor 2 is further included between the steering core 111 and the electrostatic capacitance sensor 2. In such a configuration, the heater 114 is disposed more inwardly than the shield electrode 25, hence an influence of the detection signal due to the heater 114 can be eliminated to detect whether the hand of the occupant is touching the wheel 11 or not. Moreover, in the present embodiment also, similarly to in the first embodiment, the electrostatic capacitance sensor 2 is disposed divided into two regions of the wheel 11, hence in the present embodiment, the heater can be switched ON only for a region touched by the hand of the occupant, and power consumption reduction is possible.

### [3. Other Embodiments]

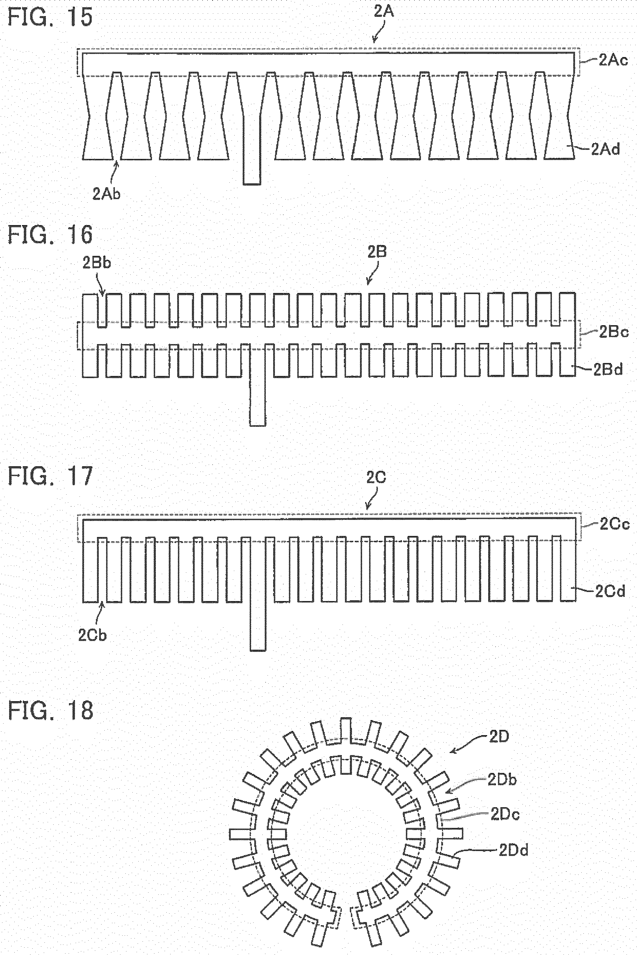

Next, other embodiments of the present invention will be described. In Fig. 5, one example of a planar shape of the electrostatic capacitance sensor according to the present invention was shown, but the planar shape of the electrostatic capacitance sensor 2 does not necessarily need to be configured similarly to the shape shown in Fig. 5, and is adoptable, provided it is a shape capable of being wrapped around the steering core 111 due to having the plurality of notches 2b. For example, the first embodiment adopted a shape where the second portion 2d extends out in a direction intersecting the extension direction of the wheel 11, from both sides of the first portion 2c that follows the extension direction of the wheel 11, but as shown in Fig. 15, an electrostatic capacitance sensor 2A may also be configured by: a first portion 2Ac extending along the wheel 11; and a second portion 2Ad extended out so as to be orthogonal to the first portion from only one side of the first portion 2Ac. The second portion 2Ad is formed such that its width narrows with increasing distance from the first portion 2Ac, and conversely its width broadens from its central portion to become thickest at its tip. In this embodiment also, the first portion 2Ac is mounted on an outermost circumference of the steering core 111, and a portion whose width is narrowest of the second portion 2Ad is mounted on an innermost circumference of the steering core 111. Due to this embodiment, the second portion 2Ad is provided only from one side of the first portion 2Ac, hence mounting to the steering core 111 becomes even easier. Moreover, when the second portion 2Ad is wrapped around the steering core 111, the electrostatic capacitance detecting electrode 22 can be reliably provided to an inner circumference of the steering core 111 where detection becomes most difficult, hence detection sensitivity improves. Note that in the first embodiment, the second portion 2Ad is formed in a trapezoidal shape in which the tip portion is narrower than the base end portion, but as shown in Figs. 16 and 17, as electrostatic capacitance sensors 2B and 2C, it is also possible for second portions 2Bd and 2Cd to have their widths matched to widths of their tip portions, and be formed in a strip form. In the case of such a shape, processing becomes easy.

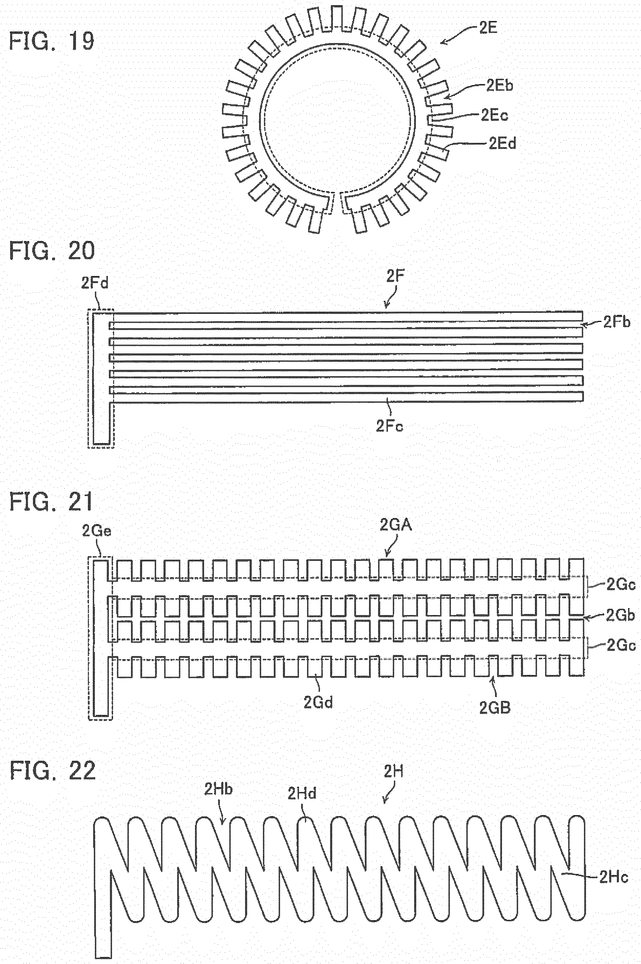

Moreover, the first portion does not necessarily need to be formed in a rectangular shape, provided it is a shape capable of being wrapped around the steering core 111 due to having the plurality of notches. That is, as shown in Figs. 18 and 19, for example, as electrostatic capacitance sensors 2D and 2E, it is also possible for first portions 2Dc and 2Ec to be formed in an annular shape. The first portions 2Dc and 2Ec are formed in an annular shape similar to the shape of the steering core 111, hence the electrostatic capacitance sensors 2D and 2E can be affixed from a surface in a single-side direction of the steering core 111, and even simpler installation work is enabled. Moreover, there is an advantage that, since the first portions 2Dc and 2Ec are configured in an annular shape similar to the shape of the steering core 111, it is difficult for a crease to occur.

Furthermore, as shown in Fig. 20, as an electrostatic capacitance sensor 2F, it is also possible to configure such that, for example, instead of dividing the second portion 2d, a first portion 2Fc formed along the wheel 11 is divided into a plurality, and one second portion 2Fd orthogonal to the first portion 2Fc is provided so as to connect the second portion 2Fd and the first portion 2Fc. By forming in this way, an affixing degree of freedom improves. Moreover, as shown in Fig. 21, it is also possible, for example, to further branch a first portion 2Gc into electrostatic capacitance sensors 2GA and 2GB from a joining portion 2Ge, and extend the second portion 2Gd out from this branched first portion 2Gc. In the case of adopting a pattern where the joining portion 2Ge is branched, it is possible to install the electrostatic capacitance sensor 2 also in a steering core 111 having a portion requiring fine detection or a particular shape.

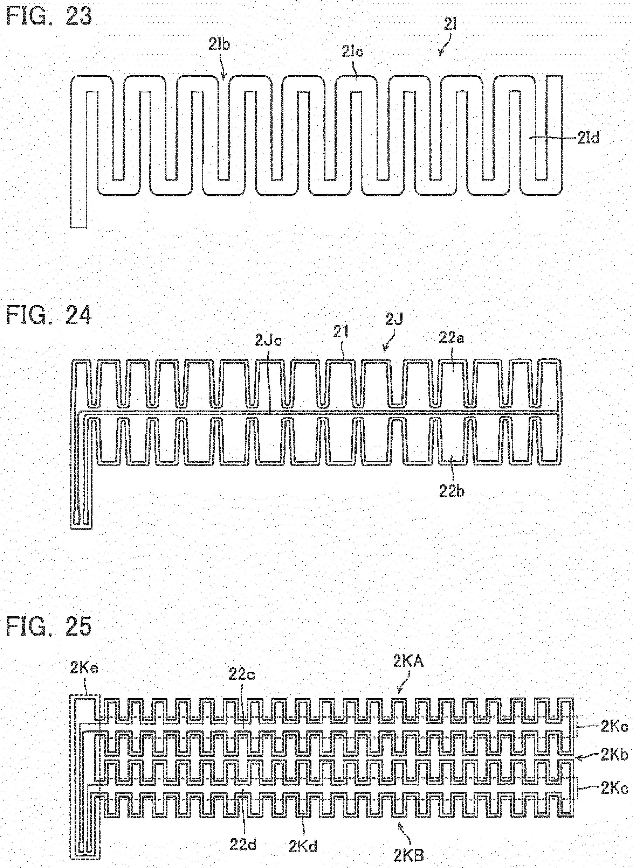

Furthermore, as shown in Figs. 22 and 23, as electrostatic capacitance sensors 2H and 2I, it is also possible to configure so as to form first portions 2Hc and 2Ic and second portions 2Hd and 21d such that a plurality of notches 2Hb and 2Ib are formed alternately and attain a zigzag pattern as a whole. These embodiments result in advantages that, since the first portions 2Hc and 21c are not straight lines joined in a transverse direction in the drawing, they can be appropriately installed even if a mounting position on the steering core 111 somewhat deviates, and moreover it is difficult for them to get wrinkled.

Fig. 24 divides the electrostatic capacitance detecting electrode 22 in the first embodiment into two in a direction intersecting the extension direction of the wheel 11 and assumes an upper side in the drawing of a first portion 2Jc following the extension direction of the wheel 11 to be an electrostatic capacitance detecting electrode 22a and a lower side thereof to be an electrostatic capacitance detecting electrode 22b. These electrostatic capacitance detecting electrodes 22a and 22b are configured each independently capable of detecting an electrostatic capacitance. Due to this embodiment, when one only one of the electrostatic capacitance detecting electrodes 22a and 22b has detected contact of the hand of the occupant, a contact range on the wheel 11 of the hand of the occupant is narrow, hence the hand of the occupant is determined to have touched the wheel 11, and when both have detected contact of the hand of the occupant, the contact range of the hand of the occupant is a range close to 180° covering both of the two electrostatic capacitance detecting electrodes 22a and 22b, hence the hand of the occupant is determined to have gripped the wheel 11. This makes it possible for various kinds of equipment to be controlled in an optimal state.

Fig. 25 has respective separate electrostatic capacitance detecting electrodes 22c and 22d formed in upper/lower-branched electrostatic capacitance sensors 2KA and 2KB of the embodiment shown in Fig. 21, and similarly to as described above, these may be configured so as to be independently capable of detection of an electrostatic capacitance. In this case also, similarly to in the previous embodiment, discrimination between touching and gripping of the hand of the occupant is enabled. Due to this embodiment, there is an advantage that, since the electrostatic capacitance sensors 2KA and 2KB are upper/lower-branched, it can be prevented from misdetection as "gripping" when it has only touched, and detection precision improves.

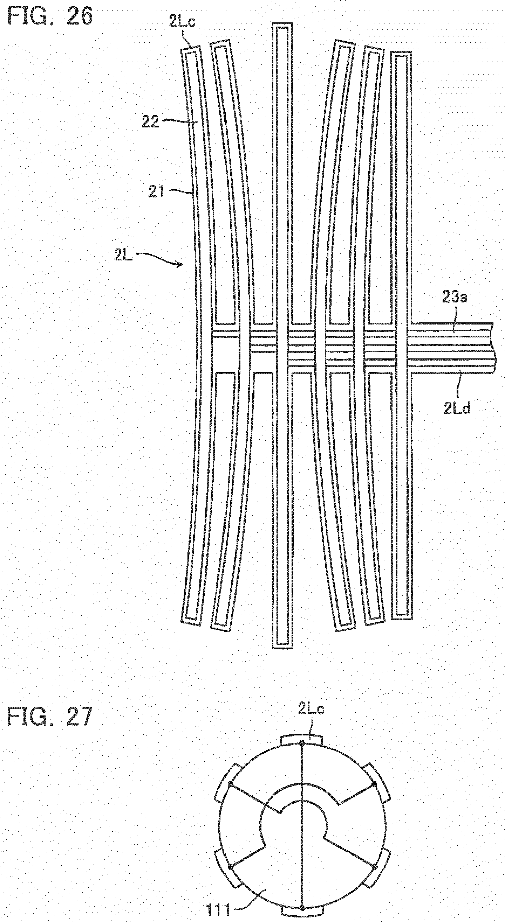

An electrostatic capacitance sensor 2L of Fig. 26 is provided with a plurality of (in this example, six) first portions 2Lc that follow the extension direction of the wheel 11, and as shown in Fig. 27, an example is shown configured such that the six first portions 2Lc are disposed with a certain spacing in a circumferential direction of the steering core 111. Fellow electrostatic capacitance detecting electrodes 22 opposingly disposed in a mounting state in the steering core 111, of the six first portions 2Lc, are commonly connected. A second portion 2Ld extending in a direction intersecting the first portion 2Lc has three wiring layers 23a formed therein, and each wiring layer 23a connects the fellow electrostatic capacitance detecting electrodes 22 included in an identical pair.

Due to this embodiment, when the hand of the occupant has covered an angular range in which are disposed the electrostatic capacitance detecting electrodes 22 of the plurality of first portions 2Lc adjacent in the circumferential direction of the steering core 111, a plurality of pairs of the electrostatic capacitance detecting electrodes 22 detect contact of a detection target, hence it can be determined that the hand of the occupant is in a state of gripping the wheel 11. On the other hand, when the hand of the occupant has only touched the wheel 11, only the electrostatic capacitance detecting electrodes 22 of the first portions 2Lc belonging to one pair detect contact of the detection target, hence it can be determined that the hand of the occupant is touching the wheel 11.

Note that in this embodiment, the first portions 2Lc mounted on the outer circumferential portion and the inner circumferential portion of the wheel 11, of the first portions 2Lc extending along the wheel 11 have a shape extending substantially linearly, and the first portions 2Lc disposed between those are formed in an arc shape matching a curvature of the wheel 11. A radius of curvature of an arc-shaped portion should be determined in view of the likes of flexibility and elasticity of the first portion 2Lc including the flexible substrate 21. Moreover, the first portion 2Fb of the embodiment shown in Fig. 20 may be configured formed in an arc shape of the kind shown in Fig. 24.

### DESCRIPTION OF REFERENCE NUMERALS

- 1: steering
- 2: electrostatic capacitance sensor
- 2a: contact wiring
- 2b: notch
- 2c: first portion
- 2d: second portion
- 3: control unit
- 11: wheel
- 12: steering column
- 21: flexible substrate
- 22: electrostatic capacitance detecting electrode
- 221: surface wiring layer
- 222: electrode layer
- 24: resist layer
- 25: shield electrode
- 251: reverse surface wiring layer
- 252: shield layer
- 27: adhesive layer
- 111: steering core
- 112: cushioning material
- 113: steering skin
- 114: heater

## Claims

1. An electrostatic capacitance sensor (2) mounted in a steering (1), comprising:
a flexible substrate (21) having an insulating property; and
an electrostatic capacitance detecting electrode (22) provided on the flexible substrate (21),
**characterized in**
the flexible substrate (21) including:
a first portion (2c) following an extension direction of a wheel (11) of the steering (1); and
a second portion (2d) extending out from the first portion (2c) in a direction intersecting the extension direction of the wheel (11) of the steering (1);
the electrostatic capacitance detecting electrode (22) including:
a wiring (221) made of silver or copper bordering an outline shape of the flexible substrate; and
an electrode layer (222) formed by filling the inside of the wiring (221) by carbon, and
the electrostatic capacitance sensor (2) being formed so as to completely cover a steering core (111).

2. The electrostatic capacitance sensor (2) according to claim 1, wherein
at least one of the first portion (2c) and the second portion (2d) is divided into a plurality.

3. The electrostatic capacitance sensor (2) according to claim 1, wherein
a shield electrode (25) is included on a reverse surface of the flexible substrate (21).

4. The electrostatic capacitance sensor (2) according to claim 1, wherein
the electrostatic capacitance detecting electrode (22) is divided into a plurality in the direction intersecting the extension direction of the wheel (11) of the steering (1), and adjacent electrostatic capacitance detecting electrodes (22) are configured so as to each independently be capable of detecting an electrostatic capacitance.

5. The electrostatic capacitance sensor (2) according to claim 4, wherein
the electrostatic capacitance detecting electrode (22) is divided into a plurality of groups such that the fellow adjacent electrostatic capacitance detecting electrodes (22) each belong to a different group, and
a plurality of the electrostatic capacitance detecting electrodes (22) belonging to an identical group are commonly connected.

6. The electrostatic capacitance sensor (2) according to claim 1, wherein the wiring (221) of the electrostatic capacitance detecting electrode (22) further includes a mesh portion having a mesh shape formed on the inside of the wiring (221).

7. A steering (1), comprising:
a steering core (111); and
an electrostatic capacitance sensor (2) mounted on the steering core (111),
the electrostatic capacitance sensor (2) comprising:
a flexible substrate (21) having an insulating property; and
an electrostatic capacitance detecting electrode (22) provided on the flexible substrate (21),
**characterized in**
the flexible substrate (21) including: a first portion (2c) following an extension direction of a wheel (11) of the steering (1); and a second portion (2d) extending out from the first portion (2c) in a direction intersecting the extension direction of the wheel (11) of the steering (1),
the electrostatic capacitance detecting electrode (22) including:
a wiring (221) made of silver or copper bordering an outline shape of the flexible substrate; and
an electrode layer (222) formed by filling the inside of the wiring (221) by carbon, and
and the electrostatic capacitance sensor (2) being formed so as to completely cover the steering core (111).

8. The steering (1) according to claim 7, wherein
a shield electrode (25) is included on a reverse surface of the flexible substrate (21).

9. The steering (1) according to claim 8, wherein
a heater (114) that generates heat according to a detection signal of the electrostatic capacitance sensor (2) is included between the steering core (111) and the electrostatic capacitance sensor (2).

10. The steering (1) according to any one of claims 7 to 9, wherein
the steering core (111) is mounted with a cushioning material (112) that covers the electrostatic capacitance sensor (2).

11. The steering (1) according to claim 7, wherein
the electrostatic capacitance detecting electrode (22) is divided into a plurality in the direction intersecting the extension direction of the wheel (11) of the steering (1), and adjacent electrostatic capacitance detecting electrodes (22) are configured so as to each independently be capable of detecting an electrostatic capacitance.

12. The steering (1) according to claim 11, wherein
the electrostatic capacitance detecting electrode (22) is divided into a plurality of groups such that the fellow adjacent electrostatic capacitance detecting electrodes (22) each belong to a different group, and
a plurality of the electrostatic capacitance detecting electrodes (22) belonging to an identical group are commonly connected.

13. The steering (1) according to claim 8, wherein the wiring (221) of the electrostatic capacitance detecting electrode (22) further includes a mesh portion having a mesh shape formed on the inside of the wiring (221).

## Patentansprüche

1. Elektrostatischer Kapazitäts-Sensor (2), der in einer Lenkung (1) installiert ist, wobei er umfasst:
ein flexibles Substrat (21), das Isoliervermögen aufweist; und
eine elektrostatische Kapazitäts-Erfassungselektrode (22), die sich an dem flexiblen Substrat (21) befindet,
**dadurch gekennzeichnet, dass**
das flexible Substrat (21) enthält:
einen ersten Abschnitt (2c), der einer Verlaufsrichtung eines Rades (11) der Lenkung (1) folgt; sowie
einen zweiten Abschnitt (2d), der sich von dem ersten Abschnitt (2c) aus in einer Richtung erstreckt, die die Verlaufsrichtung des Rades (11) der Lenkung (1) schneidet;
wobei die elektrostatische Kapazitäts-Erfassungselektrode (22) enthält:
eine Verdrahtung (221), die aus Silber oder Kupfer besteht und eine Umrissform des flexiblen Substrats begrenzt; sowie
eine Elektroden-Schicht (222), die ausgebildet wird, indem das Innere der Verdrahtung (221) mit Kohlenstoff gefüllt wird, und
wobei der elektrostatische Kapazitäts-Sensor (2) so ausgebildet ist, dass er einen Kern (111) der Lenkung (steering core) vollständig abdeckt.

2. Elektrostatischer Kapazitäts-Sensor (2) nach Anspruch 1, wobei
der erste Abschnitt (2c) oder/und der zweite Abschnitt (2d) mehrfach unterteilt ist/sind.

3. Elektrostatischer Kapazitäts-Sensor (2) nach Anspruch 1, wobei
eine Abschirm-Elektrode (25) an einer hinteren Fläche des flexiblen Substrats (21) enthalten ist.

4. Elektrostatischer Kapazitäts-Sensor (2) nach Anspruch 1, wobei
die elektrostatische Kapazitäts-Erfassungselektrode (22) in der Richtung, die die Verlaufsrichtung des Rades (11) der Lenkung (1) schneidet, mehrfach unterteilt ist und benachbarte elektrostatische Kapazitäts-Erfassungselektroden (22) so eingerichtet sind, dass sie jeweils unabhängig eine elektrostatische Kapazität erfassen können.

5. Elektrostatischer Kapazitäts-Sensor (2) nach Anspruch 4, wobei
die elektrostatische Kapazitäts-Erfassungselektrode (22) in eine Vielzahl von Gruppen so unterteilt ist, dass die zusammengehörigen benachbarten elektrostatischen Kapazitäts-Erfassungselektroden (22) jeweils zu einer anderen Gruppe gehören, und
eine Vielzahl der zu einer identischen Gruppe gehörenden elektrostatischen Kapazitäts-Erfassungselektroden (22) gemeinsam verbunden sind.

6. Elektrostatischer Kapazitäts-Sensor (2) nach Anspruch 1,
wobei die Verdrahtung (221) der elektrostatischen Kapazitäts-Erfassungselektrode (22) des Weiteren einen Geflecht-Abschnitt enthält, der die Form eines an der Innenseite der Verdrahtung (221) ausgebildeten Geflechts hat.

7. Lenkung (1), die umfasst:
einen Kern (111) der Lenkung (steering core); und
einen an dem Kern (111) der Lenkung installierten elektrostatischen Kapazitäts-Sensor (2),
wobei der elektrostatische Kapazitäts-Sensor (2) umfasst:
ein flexibles Substrat (21), das Isoliervermögen aufweist; und
eine elektrostatische Kapazitäts-Erfassungselektrode (22), die sich an dem flexiblen Substrat (21) befindet,
**dadurch gekennzeichnet, dass**
das flexible Substrat (21) einen ersten Abschnitt (2c), der einer Verlaufsrichtung eines Rades (11) der Lenkung (1) folgt, und einen zweiten Abschnitt (2d) enthält, der sich von dem ersten Abschnitt (2c) aus in einer Richtung erstreckt, die die Verlaufsrichtung des Rades (11) der Lenkung (1) schneidet;
wobei die elektrostatische Kapazitäts-Erfassungselektrode (22) enthält:
eine Verdrahtung (221), die aus Silber oder Kupfer besteht und eine Umrissform des flexiblen Substrats begrenzt; sowie
eine Elektroden-Schicht (222), die ausgebildet wird, indem das Innere der Verdrahtung (221) mit Kohlenstoff gefüllt wird, und
wobei der elektrostatische Kapazitäts-Sensor (2) so ausgebildet ist, dass er den Kern (111) der Lenkung vollständig abdeckt.

8. Lenkung (1) nach Anspruch 7, wobei
eine Abschirm-Elektrode (25) an einer hinteren Fläche des flexiblen Substrats (21) enthalten ist.

9. Lenkung (1) nach Anspruch 8, wobei
eine Heizeinrichtung (114), die entsprechend einem Erfassungs-Signal des elektrostatischen Kapazitäts-Sensors (2) Wärme erzeugt, zwischen dem Kern (111) der Lenkung und dem elektrostatischen Kapazitäts-Sensor (2) enthalten ist.

10. Lenkung (1) nach einem der Ansprüche 7 bis 9, wobei
der Kern (111) der Lenkung mit einem dämpfenden Material (112) versehen ist, das den elektrostatischen Kapazitäts-Sensor (2) abdeckt.

11. Lenkung (1) nach Anspruch 7, wobei
die elektrostatische Kapazitäts-Erfassungselektrode (22) in der Richtung, die die Verlaufsrichtung des Rades (11) der Lenkung (1) schneidet, mehrfach unterteilt ist und benachbarte elektrostatische Kapazitäts-Erfassungselektroden (22) so eingerichtet sind, dass sie jeweils unabhängig eine elektrostatische Kapazität erfassen können.

12. Lenkung (1) nach Anspruch 11, wobei
die elektrostatische Kapazitäts-Erfassungselektrode (22) in eine Vielzahl von Gruppen so unterteilt ist, dass die zusammengehörigen benachbarten elektrostatischen Kapazitäts-Erfassungselektroden (22) jeweils zu einer anderen Gruppe gehören,
eine Vielzahl der zu einer identischen Gruppe gehörenden elektrostatischen Kapazitäts-Erfassungselektroden (22) gemeinsam verbunden sind.

13. Lenkung (1) nach Anspruch 8, wobei die Verdrahtung (221) der elektrostatischen Kapazitäts-Erfassungselektrode (22) des Weiteren einen Geflecht-Abschnitt enthält, der die Form eines an der Innenseite der Verdrahtung (221) ausgebildeten Geflechts hat.

## Revendications

1. Capteur de capacité électrostatique (2) monté dans un volant de direction (1) comprenant :
un substrat souple (21) présentant une propriété d'isolation, et
une électrode de détection de capacité électrostatique (22) disposée sur le substrat souple (21),
**caractérisé en ce que**
le substrat souple (21) inclut :
une première partie (2c) suivant la direction d'extension de la roue du volant (1), et
une seconde partie (2d) s'étendant vers l'extérieur depuis la première partie (2c) dans une direction coupant la direction d'extension de la roue (11) du volant (1),
l'électrode de détection de capacité électrostatique (22) incluant :
un câblage (221) constitué d'argent ou de cuivre jouxtant la forme du contour du substrat souple, et
une couche d'électrode (222) formée en remplissant l'intérieur du câblage (221) par du carbone, et
le capteur de capacité électrostatique (2) est formé de sorte à recouvrir complètement l'âme (111) du volant.

2. Capteur de capacité électrostatique (2) selon la revendication 1, dans lequel
au moins l'une de la première partie (2c) et de la seconde partie (2d) est divisée en une pluralité.

3. Capteur de capacité électrostatique (2) selon la revendication 1, dans lequel
une électrode formant écran (25) est incluse sur la surface opposée du substrat souple (21).

4. Capteur de capacité électrostatique (2) selon la revendication 1, dans lequel
l'électrode de détection de capacité électrostatique (22) est divisée en une pluralité dans la direction coupant la direction d'extension de la roue (11) du volant (1), et des électrodes adjacentes de détection de capacité électrostatique (22) sont configurées de sorte à pouvoir détecter indépendamment une capacité électrostatique.

5. Capteur de capacité électrostatique (2) selon la revendication 4, dans lequel
l'électrode de détection de capacité électrostatique (22) est divisée en une pluralité de groupes de sorte à ce que les électrodes adjacentes soeurs de détection de capacité électrostatique (22) appartiennent chacune à un groupe différent, et
les différentes électrodes de détection de capacité électrostatique (22) appartenant à un groupe identique sont reliées ensemble.

6. Capteur de capacité électrostatique (2) selon la revendication 1, dans lequel le câblage (221) de l'électrode de détection de capacité électrostatique (22) inclut en outre une partie maillée présentant la forme d'un maillage formé sur l'intérieur du câblage (221).

7. Volant de direction (1) comprenant :
une âme (111) de volant, et
un capteur de capacité électrostatique (2) monté sur l'âme (111) du volant,
le capteur de capacité électrostatique (2) comprenant :
un substrat souple (21) présentant une propriété d'isolation, et
une électrode de détection de capacité électrostatique (22) disposée sur le substrat souple (21),
**caractérisé en ce que**
le substrat souple (21) inclut : une première partie (2c) suivant la direction d'extension de la roue du volant (1), ainsi qu'une seconde partie (2d) s'étendant vers l'extérieur depuis la première partie (2c) dans une direction coupant la direction d'extension de la roue (11) du volant (1),
l'électrode de détection de capacité électrostatique (22) incluant :
un câblage (221) constitué d'argent ou de cuivre jouxtant la forme du contour du substrat souple, et
une couche d'électrode (222) formée en remplissant l'intérieur du câblage (221) par du carbone, et
le capteur de capacité électrostatique (2) est formé de sorte à recouvrir complètement l'âme (111) du volant.

8. Volant de direction (1) selon la revendication 7, dans lequel
une électrode formant écran (25) est incluse sur la surface opposée du substrat souple (21).

9. Volant de direction (1) selon la revendication 7, dans lequel
un dispositif de chauffage (114) qui génère de la chaleur en fonction d'un signal de détection du capteur de capacité électrostatique (2) est inclus entre l'âme (111) du volant et le capteur de capacité électrostatique (2).

10. Volant de direction (1) selon l'une quelconque des revendications 7 à 9, dans lequel
l'âme (111) du volant est montée avec un matériau de rembourrage (112) qui recouvre le capteur de capacité électrostatique (2).

11. Volant de direction (1) selon la revendication 7, dans lequel
l'électrode de détection de capacité électrostatique (22) est divisée en une pluralité dans la direction coupant la direction d'extension de la roue (11) du volant (1), et des électrodes adjacentes de détection de capacité électrostatique (22) sont configurées de sorte à pouvoir détecter indépendamment une capacité électrostatique.

12. Volant de direction (1) selon la revendication 11, dans lequel
l'électrode de détection de capacité électrostatique (22) est divisée en une pluralité de groupes de sorte à ce que les électrodes adjacentes soeurs de détection de capacité électrostatique (22) appartiennent chacune à un groupe différent, et
les différentes électrodes de détection de capacité électrostatique (22) appartenant à un groupe identique sont reliées ensemble.

13. Volant de direction (1) selon la revendication 8, dans lequel le câblage (221) de l'électrode de détection de capacité électrostatique (22) inclut en outre une partie maillée présentant la forme d'un maillage formé sur l'intérieur du câblage (221).
